# EUROPÄISCHE PATENTSCHRIFT

(11) **EP 0 609 942 B1**
(45) Veröffentlichungstag und Bekanntmachung des Hinweises auf die Patenterteilung: **08.05.1996**
(21) Anmeldenummer: 94200197.5
(22) Anmeldetag: 26.01.1994
(51) Int. Cl.: H05K 9/00

(54) **Formteile aus Kunststoff**
Moulded plastic parts
Pièces moulées en matière plastique

(30) Priorität: 04.02.1993 DE 4303175
(43) Veröffentlichungstag der Anmeldung: 10.08.1994
(73) Patentinhaber: Philips Patentverwaltung GmbH, 22335 Hamburg (DE); Philips Electronics N.V., 5621 BA Eindhoven (NL)
(72) Erfinder: Füchtenkort, Manfred, D-20097 Hamburg (DE); Schmitt, Norbert, D-20097 Hamburg (DE)
(74) Vertreter: Erdmann, Anton, Dipl.-Ing.

(56) Entgegenhaltungen:
- EP-A- 0 332 327
- EP-A- 0 378 392
- FR-A- 2 680 270
- IBM TECHNICAL DISCLOSURE BULLETIN, Bd.27, Nr.3, August 1984 Seite 1730 BERRY 'METALLIC FILLED STRUCTURAL FOAM MACHINE CABINETS'

## Beschreibung

Die Erfindung bezieht sich auf Formteile aus Kunststoff mit eingelagerten, elektrisch leitenden Füllstoffen, z.B. Spritzgußteile, zur Fertigung von abgeschirmten Gehäusen der elektrischen Nachrichtentechnik oder dergl..

Zur Abschirmung elektrischer oder elektronischer Baugruppen vor elektromagnetischen Feldern werden vorzugsweise Metallgehäuse eingesetzt. Diese Metallgehäuse haben den Nachteil, daß sie nicht beliebig gestaltet werden können. Es ist ferner bekannt, Kunststoffgehäuse zu verwenden, die eine z.B. durch Bedampfen, Galvanisieren oder Besprühen gefertigte, elektrisch leitfähige Schicht aufweisen. Diese Beschichtung erfordert jedoch einen zusätzlichen Aufwand. Schließlich wird seit einiger Zeit diese Nacharbeit dadurch eingespart, daß zur Fertigung von Gehäusen oder dergl. Kunststoffe mit eingearbeiteten elektrisch leitfähigen Füllstoffen verwendet worden. Um bei derartigen Isolierstoffen eine optimale Schirmwirkung zu erzielen, muß das Schirmgehäuse einen geschlossenen Faradayschen Käfig bilden. Bei Gehäusen, die aus derartig aufgebauten, einzelnen Kunststoff-Formteilen hergestellt sind, ist eine elektrisch leitende Verbindung zwischen den zusammengesetzten Gehäuseteilen vielfach nicht gewährleistet. Daher ist bei diesen Gehäusen zusätzlich eine Verletzung der aneinander stoßenden Oberflächen der einzelnen Bauteile erforderlich, was einen zusätzlichen, kostenintensiven Aufwand bedeutet.

Durch IBM-Technical Disclosure Bulletin, Vol. 27, Nr. 3, Aug. 84, Seite 1730, ist ein Kunststoffgehäuse mit einer eingelegten Metallfüllung bekannt geworden. Diese Entgegenhaltung zeigt einerseits die Herstellung eines derartigen Gehäuses, wobei über eine Düse sowohl Kunststoff als auch metallisches Füllmaterial in eine metallische Form eingebracht wird. Andererseits zeigt die Entgegenhaltung den Ausschnitt eines auf diese Weise gefertigten Gehäuses, in welches von außen ein metallischer Einsatz eingebracht ist. Dieser Einsatz ist kontaktiert mit der metallischen Füllmasse innerhalb des Kunststoffgehäuses und dient zur Herstellung einer Erdung.

Durch die EP-A-0 378 392 ist ein Gehäuse für elektronische Apparate bekannt geworden, das zwei Schalen aus elektrisch leitendem Material enthält, die jeweils mit einer isolierenden Schicht umkleidet sind. Zur Verbindung der beiden Gehäuseschalen sind schraubenförmige Verbindungselemente vorgesehen, die mit dem Schraubenende in das leitfähige Material der einen Schale eingreifen und die im Bereich des Schraubenkopfes mit einem zackenförmigen Element versehen sind, welches mit seinen Zacken die Isolierschicht der anderen Schale durchdringt und in das leitfähige Material dieser Schale eindringt.

Der Erfindung liegt die Aufgabe zugrunde, Formteil aus Kunststoff mit eingelagerten elektrisch leitfähigen Füllstoffen der eingangs genannten Art derart zu gestalten, daß bei einem Zusammenbau solchere Formteile eine einwandfreie Kontaktierung der eingelagerten leitfähigen Füllstoffe gewährleistet ist.

Diese Aufgabe wird gemäß der Erfindung dadurch gelöst, daß die Formteile an ihren Verbindungsstellen mit gleichartigen Formteilen oder elektrisch leitenden Bauteilen so gestaltet sind, daß nach Entfernung von Teilbereichen der Formteile oder von extra angeformten Ansätzen die elektrisch leitenden Füllstoffe freiliegen. Somit wird beim Zusammenbau von Formteilen dieser Art eine elektrische Kontaktierung ermöglicht, ohne daß eine weitere Bearbeitung notwendig ist.

Die heraustrennbaren Teilbereiche und/oder die abbrechbaren Ansätze sind dab ei über Sollbruchstellen mit den Formteilen verbunden. Diese Bauweise ermöglicht ein einfaches Abbrechen oder Abschneiden der heraustrennbaren Teile oder der abbrechbaren Ansätze. Dabei kann in Ausgestaltung der Erfindung vorgesehen sein, daß die Teilbereiche und/oder die Ansätze über einzelne Stege oder über geschwächte Bereiche mit den Formteilen verbunden sind.

Die heraustrennbaren Teilbereiche oder die abtrennbaren Ansätze können z.B. auf einfache Weise in Form von Angüssen bei der Herstellung der Formteile hergestellt werden.

In der Zeichnung sind in den Fig. 1 bis 13 Ausführungsbeispiele des Gegenstandes gemäß der Erfindung schematisch dargestellt. Die dargestellten Kunststoffgehäuse bzw. Formteile besitzen elektrisch leitende Füllstoffe.
Fig. 1 zeigt in perspektivischer Ansicht ein Gehäuse mit einer Angußstange,
Fig. 2 zeigt einen Teilschnitt A-A gemäß Fig. 1,
Fig. 3 zeigt in perspektivischer Ansicht ein Gehäuse mit einem Ringanguß,
Fig. 4 zeigt einen Teilschnitt gemäß B-B nach Fig. 3,
Fig. 5 zeigt in perspektivischer Ansicht einen Mehrfach-Kontaktanguß,
Fig. 6 zeigt eine Teilansicht in Richtung Z gemäß Fig. 5,
Fig. 7 zeigt in perspektivischer Ansicht ein plattenförmiges Formstück aus Kunststoff mit einem ausbrechbaren Teilbereich,
Fig. 8 zeigt in einem Querschnitt C-C gemäß Fig. 7 das Formteil mit ausgebrochenem Teilstück und einem eingesetzten Gegenstück,
Fig. 9 zeigt ein Kunststoff-Formteil mit einem über geschwächte Bereiche heraustrennbaren kreisförmigen Verschluß,
Fig. 10 zeigt einen Schnitt D-D gemäß Fig. 8 mit herausgetrenntem Verschluß,
Fig. 11 zeigt ein Kunststoff-Formteil mit einem in eine kreisförmige Öffnung eingesetzten Nietbolzen,
Fig. 12 zeigt einen Schnitt E-E gemäß Fig. 11, und
Fig. 13 zeigt die zusammengebauten Teile gemäß Fig. 9 bis 12.

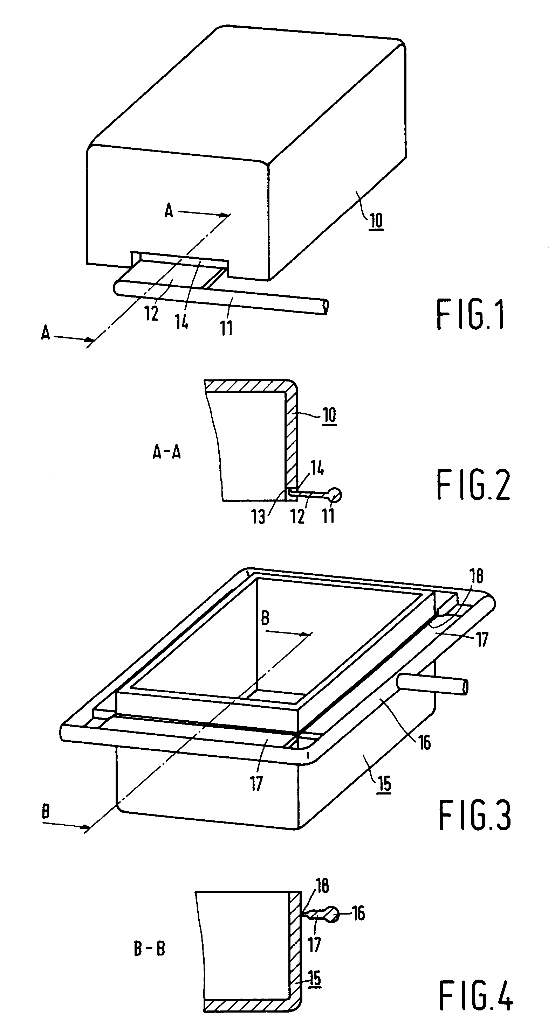

Das Gehäuse 10 gemäß Fig. 1 und 2 besitzt eine Angußstange 11, die über einen Steg 12 und eine Sollbruchstelle 13 an das Gehäuse 10 angeformt ist. Durch Abbrechen der Angußstange 11 und des Steges 12 entsteht eine Bruch-Kontaktstelle 14, an der die in das Kunststoffgehäuse eingelagerten elektrisch leitfähigen Füllstoffe freiliegen.

Gemäß Fig. 3 und 4 ist an ein Gehäuse 15 ein Ringanguß 16 über Stege 17 angeformt, bei deren Abbruch eine umlaufende Bruch-Kontaktstelle 18 am Gehäuse entsteht.

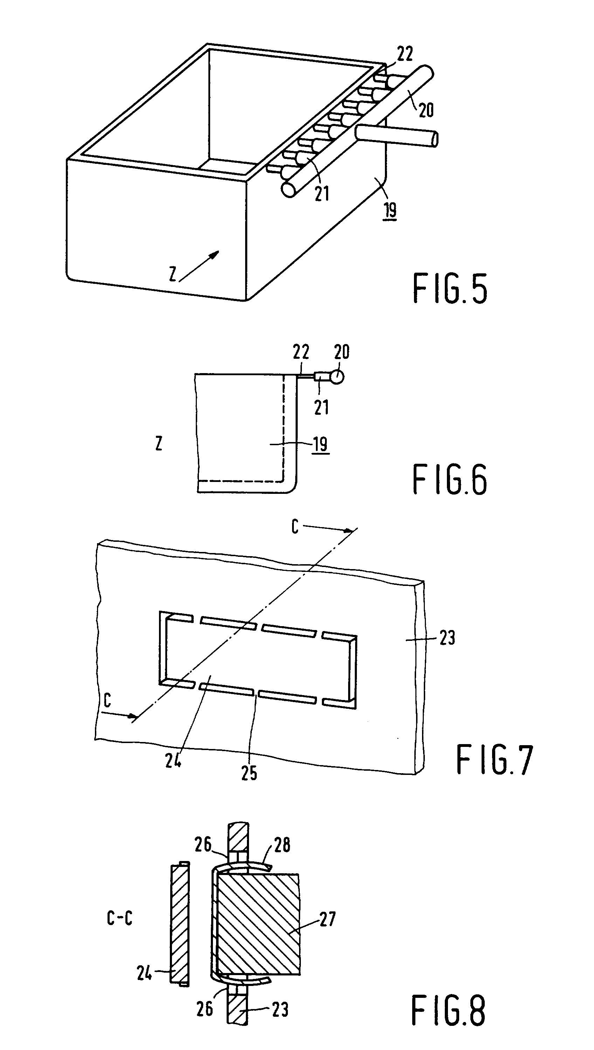

Gemäß Fig. 5 und 6 ist an ein Gehäuse 19 eine Angußstange 20 über mehrere Stege 21 angeformt, die nach Abbrechen einzelne, diskrete Bruch-Kontaktstellen 22 bilden.

Fig. 7 und 8 zeigen ein Teil-Formstück 23 mit einem Teilbereich 24, der nur noch über Stege 25 mit dem Formteil 23 verbunden ist. Nach Herausbrechen des Teilbereiches 24 gemäß Fig. 8 entstehen an den Bruchstellen freiliegende Kontaktflächen 26 zu den eingelagerten Füllstoffen. Mit 27 ist eine Leiterplatte bezeichnet, die über ein metallisches Federelement 28 in die Öffnung eingesetzt ist und über die Kontaktflächen 26 kontaktiert ist.

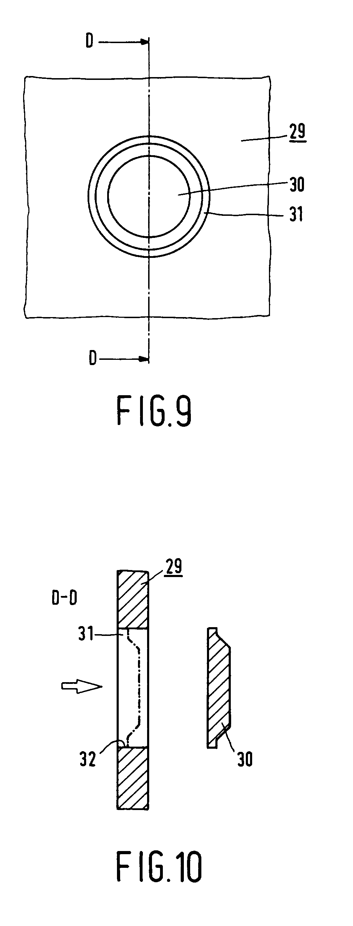

Fig. 9 und 10 zeigen ein erstes Formteil 29 mit einem kreisförmigen Teilbereich 30, der über eine geschwächte ringförmige Zone 31 mit dem Formteil 29 verbunden ist und gemäß Fig. 10 durch Herausschneiden herausgetrennt werden kann. Dabei entsteht eine ringförmige Kontaktfläche 32.

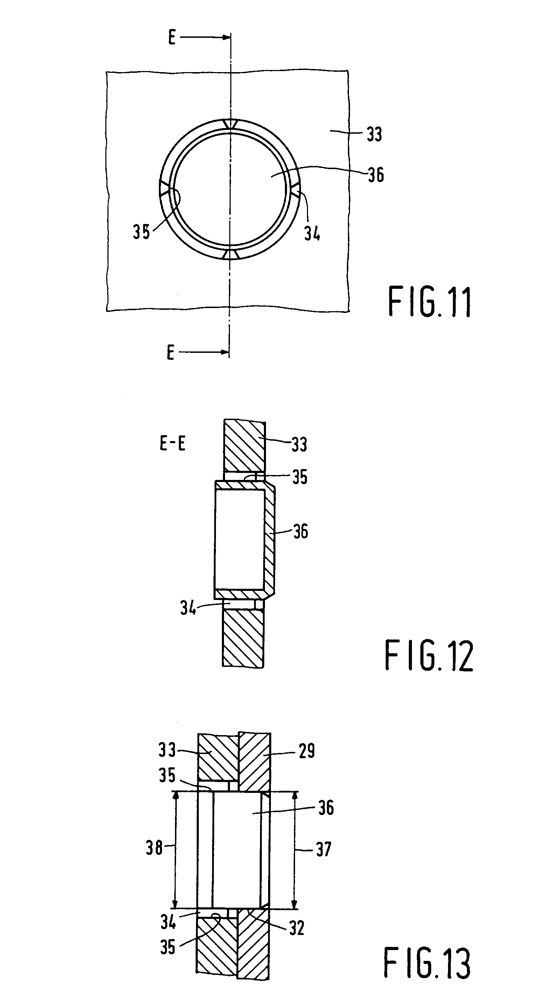

Fig. 11 und 12 zeigen ein zweites Formteil 33, aus dem ebenfalls ein nicht dargestellter kreisförmiger Teilbereich so herausgetrennt wurde, daß vier Stege 34 mit stirnförmigen Kontaktflächen 35 stehen geblieben sind. In diese Öffnung ist ein metallischer Nietbolzen 36 eingeschoben und über die Kontaktflächen 35 kontaktiert.

Gemäß Fig. 13 sind die Formteile 29 und 33 zusammengebaut, wobei die Öffnung im Formteil 29 einen Durchmesser 37 und die Öffnung im Formteil 33 einen Durchmesser 38 besitzt. Der eingeschobene Nietbolzen 36 ist mit dem Formteil 33 über die Kontaktflächen 35 der Stege 34 und mit dem Formteil 29 über die ringförmige Kontktfläche 32 kontaktiert.

## Patentansprüche

1. Formteile aus Kuststoff mit eingelagerten, elektrisch leitfähigen Füllstoffen, z.B. zur Fertigung von abgeschirmten Gehäusen für die elektrische Nachrichtentechnik, dadurch gekennzeichnet, daß die Formteile (23, 10) an Verbindungsstellen mit gleichartigen Formteilen oder elekrisch leitenden Bauteilen (28) so gestaltet sind, daß nach Entfernung von Teilbereichen (24) der Formteile (23) oder von extra angeformten Ansätzen (11) die elektrisch leitenden Füllstoffe freiliegen.

2. Formteile nach Anspruch 1, dadurch gekennzeichnet, daß die Teilbereiche (24, 30) und/oder die Ansätze (11) über Stege (25, 12) oder über geschwächte Bereiche (31) mit den Formteilen (23, 29, 10) verbunden sind.

3. Formteile nach Anspruch 1 oder 2, dadurch gekennzeichnet, daß die Ansätze (11) als Angüsse gefertigt sind.

## Claims

1. Moulded parts of synthetic material with incorporated electrically conducting filler materials, for example for the manufacture of screened housings in electrical communication technology, characterized in that the moulded parts (23, 10) are so constructed at their points of connection with similar moulded parts or with electrically conducting components (28) that the electrically conducting filler materials are exposed after the removal of regions (24) of the moulded parts (23) or the removal of additional moulded projections (11).

2. Moulded parts as claimed in Claim 1, characterized in that the regions (24, 30) and/or the projections (11) are connected to the moulded parts (23, 29, 10) via bridges (25, 12) or via thinned regions (31).

3. Moulded parts as claimed in Claim 1 or 2, characterized in that the projections (11) are manufactured as sprues.

## Revendications

1. Pièces moulées en matière plastique incorporant des charges conductrices de l'électricité, par exemple pour la fabrication de boîtiers de blindage pour les techniques de télécommunications électriques, caractérisées en ce que les pièces moulées (23, 10) sont conçues au niveau des jonctions à des pièces moulées semblables ou des composants (28) conducteurs de l'électricité, de telle sorte qu'après enlèvement de régions partielles (24) des pièces moulées (23) ou de saillies de moulage (11) supplémentaires, les charges conductrices de l'électricité soient mises à nu.

2. Pièces moulées suivant la revendication 1, caractérisées en ce que les régions partielles (24, 30) et/ou les saillies (11) sont reliées aux pièces moulées (23, 29, 10) par l'intermédiaire de traverses (25, 12) ou de régions affaiblies (31).

3. Pièces moulées suivant la revendication 1 ou 2, caractérisées en ce que les saillies (11) sont réalisées sous la forme de carottes.
